# EUROPEAN PATENT APPLICATION

(11) **EP 4 394 896 A1**
(43) Date of publication of application: **03.07.2024**
(21) Application number: 22217402.1
(22) Date of filing: 30.12.2022
(51) Int. Cl.: H01L 31/048

(54) **METHOD AND DEVICE FOR PRODUCING A PV PANEL INCLUDING A SOLAR CELL ARRANGEMENT USING INJECTION COMPRESSION MOULDING**

(71) Applicant: Sono Motors GmbH, 80935 München (DE)
(72) Inventor: THENER, Sebastian, 80935 Munich (DE); KÖHNLEIN, Dominik, 80935 Munich (DE); RIBEIRO, Eduardo, 80935 Munich (DE); RAMESHA, Harshan, 80935 Munich (DE)
(74) Representative: Qip Patentanwälte Dr. Kuehn & Partner mbB

(57) **Abstract**

A method and a moulding device (27) for producing a photovoltaic panel (1), particularly a photovoltaic vehicle body panel, are described. The method comprises: providing a photovoltaic label (3) comprising a front side polymeric stabilisation foil (11), a front side polymeric lamination foil (13), a rear side polymeric lamination foil (13) and, optionally, a rear side polymeric stabilisation foil (15) as well as a solar cell arrangement (17) interposed between the front and rear side lamination foils, and preparing a support structure (5) for supporting the photovoltaic label, wherein the support structure is prepared by arranging the photovoltaic label between two moulding halves (23, 25) of a moulding device (27) being in an opened state, fixing the photovoltaic label relative to at least one of the moulding halves, injecting a viscous polymer mass (29) to a rear surface (21) of the photovoltaic label, closing the moulding device to a closed state by pushing the moulding halves towards each other such as to compress and thereby distribute the previously injected viscous polymer mass along the rear surface of the photovoltaic label, and after solidification of the injected polymer mass thereby forming the support structure, opening the moulding device by pulling the moulding halves away from each other and removing the photovoltaic label with the support structure attached thereto from the moulding device.

## Description

### FIELD OF THE INVENTION

The present invention relates to a method for producing a photovoltaic panel, particularly for producing a photovoltaic vehicle body panel or other vehicle-related photovoltaic panel, into which a solar cell arrangement is integrated. Furthermore, the present invention relates to a moulding device being configured for implementing such a method.

### TECHNICAL BACKGROUND

The method and device described herein may be applied for producing a photovoltaic panel which may be used and/or be specifically configured for various application fields such as for installation at vehicles, on building roofs or at other structures. However, details of the approach suggested will be described herein with a focus on photovoltaic vehicle body panels. While the term "vehicle body panel" may refer to a panel which may be included in a body of any kind of vehicles such as cars, trucks, busses, mobile homes, trains, ships, air planes, etc., embodiments are described herein with reference to car body panels for simplicity of description.

In the following, the term "photovoltaic" may be abbreviated by "PV". PV cells may also be referred to as solar cells. A body panel of a vehicle including an integrated PV module may be referred to herein as PV integrated car body panel.

Conventionally, most commercially available PV panels are typically produced by providing planar, rigid, wafer-based solar cells and then laminating these solar cells between a front side glass sheet and a rear side support structure such as another glass sheet or a metal sheet. Therein, the solar cells are interposed between thin lamination foils serving for both, tightly encapsulating the solar cells and mechanically interconnecting the stack including the front and rear side sheets with the interposed solar cell arrangement. Such PV panels are also referred to as PV modules and typically have a planar structure. These PV panels are well suited for installation on buildings or in solar farms. However, such planar PV panels are hardly suited for an integration into curved surfaces such as for example surfaces of body panels of a car or another vehicle.

Approaches have been presented in which PV cells are provided at a body of a car for generating electricity to be supplied to the car. Such electricity may be used for example for charging batteries of an electric car.

For example, it has been proposed e.g. in an earlier patent application WO 2019/020718 A1 of the present applicant to provide solar cells in a body panel of a vehicle. Therein, a PV module shall be placed on top of such a body panel or, preferably, the PV module shall be integrated into the body panel. Specifically, one or more solar cells may be arranged in an air tight and water tight manner in a recess provided in a carrier structure of a car body panel.

In an alternative approach for manufacturing PV modules, it has been proposed by the present applicant in an earlier patent application WO 2020/187792 A1 to integrate a solar cell arrangement into a moulded layer formed by injection moulding. Therein, the solar cell arrangement is interposed between polymeric foils, thereby forming a so-called photovoltaic label which may be securely handled and in which the solar cells shall be for example protected against excessive mechanical stress during an injection moulding procedure.

Further approaches for a car body panel comprising an integrated solar cell arrangement have been proposed by the present applicant in earlier patent applications WO 2022/122507 A1 and DE 10 2022 101 935 A1.

In each of these prior art approaches, the panel or, specifically, the car body panel including the solar cell arrangement may be regarded as a PV module having a non-planar shape.

Possible features and characteristics of such approaches of car body panels and approaches for fabricating a car body panel including a photovoltaic module have been described by the applicant in the above mentioned patent applications as well as in further prior patent applications such as WO 2021/260021 A1 (title: "Method for fabricating a photovoltaic module including laser cutting of a photovoltaic label"), WO 2021/260024 A1 (title: "Method for fabricating a curved photovoltaic module including adapted positioning of photovoltaic cells") and DE 10 2022 108 014 A1 (title "Method for fabricating a Photovoltaic Module using In-Mould Labelling with specific Temperature Management").

Furthermore, the applicant of the present application filed another patent application in parallel, i.e. simultaneously, with the present one. This other patent application addresses details of a specific technique for arranging and fixing a PV label during a fabrication of a PV panel, such details also possibly being applicable in the approach presented in the present application.

Features and characteristics of the approaches described in the mentioned prior and/or parallel applications may also apply to the production method and device described herein and the content of these patent applications shall be incorporated in its entirety herein by reference.

### SUMMARY OF THE INVENTION AND OF EMBODIMENTS

It may be an object to provide an alternative method for producing a PV panel, for example, a PV vehicle body panel or a PV panel that may be provided on buildings or the like, in which a solar cell arrangement is integrated and which fulfils both, very high functional requirements as well as very high aesthetic requirements. Furthermore, it may be an object to provide a production method which enables a relatively simple fabrication procedure, high fabrication yield and/or low fabrication costs while providing a fabrication result as a highly functional, reliable and aesthetic PV-integrated (car body) panel. Furthermore, it may be an object to provide a moulding device being specifically configured for implementing the proposed method and enabling PV panel production in a reliable and cost efficient manner.

Such objects may be solved by the subject-matter of the independent claims. Advantageous embodiments are defined in the dependent claims and described in the following specification and visualised in the associated figures.

According to a first aspect of the present invention, a method for producing a photovoltaic panel (PV panel), particularly a photovoltaic vehicle body panel, is described. The method comprises at least the following steps, preferably in the indicated order:
(i) providing a photovoltaic label (PVL) comprising a front side polymeric stabilisation foil, a front side polymeric lamination foil, a rear side polymeric lamination foil and, optionally, a rear side polymeric stabilisation foil as well as a solar cell arrangement interposed between the front and rear side lamination foils, and
(ii) preparing a support structure for supporting the photovoltaic label.
Therein, the support structure is prepared including the following steps, preferably, but not necessarily in the indicated order:
(a) arranging the photovoltaic label between two moulding halves of a moulding device being in an opened state,
(b) fixing the photovoltaic label to either one of the moulding halves,
(c) injecting a viscous polymer mass to a rear surface of the photovoltaic label,
(d) closing the moulding device to a closed state by pushing the moving moulding half towards the fixed moulding half so as to compress and thereby distribute the previously injected viscous polymer mass along the rear surface of the photovoltaic label, and
(e) after solidification of the injected polymer mass thereby forming the support structure, opening the moulding device and removing the photovoltaic label with the support structure attached thereto from the moulding device.

According to a second aspect of the invention, a moulding device is described. The moulding device comprises:
- a core or moving side moulding half and a cavity or fixed side moulding half being displaceable relative to each other between an open state and a closed state, wherein the core side moulding half and the cavity side moulding half are configured so as to, in the closed state of the moulding device, enclose a cavity,
- a fixation arrangement configured for temporarily fixing a sheet-like photovoltaic label at the core side moulding half such that a front surface of the photovoltaic label is adjacent to an inner surface of the core side moulding half and a rear surface of the photovoltaic label is directed to and spaced apart from an inner surface of the cavity side moulding halve via the interposed cavity,
- an injection arrangement configured for injecting a viscous polymer mass into the cavity to the rear surface of the photovoltaic label upon the photovoltaic label being arranged between the core side moulding half and the cavity side moulding half.

It is noted that the core side moulding half may also be regarded or referred to as the moving moulding half of the moulding device, and the cavity side moulding half may be regarded or referred to as the fixed moulding half of the moulding device. Therefore, for opening or closing the moulding device, the core side moulding half is either moved towards the cavity side moulding half or away from it, in particular, during the closing procedure, the core side moulding half is moved towards the cavity side moulding half up to a predetermined point or closing state, whereas during the opening procedure of the moulding device, the core side moulding half is moved away from the cavity side moulding half.

Also, it is conceivable that the whole procedure takes place vice versa, if the core side moulding half is the fixed moulding half and the cavity side moulding half is the moving moulding half. Then, for the opening procedure, the cavity side moulding half will be moved away from the core side moulding half and for the closing procedure, the cavity side mould half will be moved towards the core side mould half.

Preferably, the moulding device is configured for implementing the method according to an embodiment of the first aspect of the invention.

Briefly summarised and without limiting the scope of the invention, basic ideas underlying embodiments of the invention and associated possible advantages will be roughly described as follows:
As indicated above, various approaches for producing PV panels with a potentially curved surface have been suggested. At least some of these approaches rely on a use of injection moulding techniques or, more specifically, on a use of in-mould labelling techniques. In such techniques, a viscous polymer mass including e.g. molten thermoplastic polymer material is injected into a cavity in an injection moulding device, wherein a PV label has been arranged within this cavity or has been fixed to either one of the moulding halves prior to the polymer injection.

However, while such approaches of preparing a PV panel by moulding the solar cell arrangement into a support structure prepared by conventional injection moulding appears to allow rapid production of large numbers of PV panels, it has been observed that handling the solar cell arrangement during the injection moulding procedure may be challenging. Particularly, it has been observed that there is a risk that solar cells of the solar cell arrangement break during the injection moulding procedure unless suitable provisions are made for preventing such solar cell breakage.

Actually, it has been observed that such solar cell breakage may result from the fact that, in conventional injection moulding, a thermoplastic polymer is typically injected into a cavity comprised in a mould, such injection being applied with very high pressures.

While such a process may enable fast manufacturing, it is assumed that the injected thermoplastic polymer may exert an excessive pressure and/or local pressure peaks onto the solar cells in the PV label, thereby inducing a risk of solar cell breakage.

In order to, inter alia, reduce such risk of solar cell breakage, it is therefore suggested to replace the conventional injection moulding procedure by a procedure in which a viscous polymer mass is not injected into a closed cavity in which also the PV label is arranged and wherein the polymer mass needs to be injected with very high pressures, but in which the viscous polymer mass is applied to a rear surface of the PV label in a state in which the PV label is already fixed to a moulding half of the moulding device but the moulding device is not yet fully closed and therefore the cavity is still at least slightly open.

In such an approach, the polymer mass may be injected with relatively low pressures as the moulding device is still being slightly open and as the injection itself is not alone responsible for distributing the polymer mass throughout each and every volume within the cavity. Instead, the polymer mass is first disposed on or close to the rear surface of the photovoltaic label and is then distributed along this rear surface upon the moulding device being subsequently closed by pushing its moulding halves towards each other and thereby compressing and spreading the previously disposed polymer mass. Such technique is also referred to as compression moulding or injection compression moulding. More specifically, such technique may be referred to as a combination of injection compression moulding and in-mould labelling.

Among other benefits, using such compression moulding techniques instead of conventional injection moulding techniques allows applying and subsequently distributing the polymer material with significantly lower pressures than typically used in conventional injection moulding procedures. On the one hand, this is due to the fact that the material has more space inside the cavity to flow, thereby, reducing the amount of pressure generated inside the mould. On the other hand, this depends on the material used and its corresponding viscosity, and this may also be due to the fact that the viscous polymers used in conventional injection moulding have to be heated in order to become liquid and generally have a high viscosity upon being processed. Due to such high viscosity, the thermoplastic polymers have to be injected into the cavity of the mould at very high pressures of e.g. more than 5000 tons or even more than 10000 tons and/or with very high injection velocities, in order to guarantee that the polymer material fills all portions of the cavity before excessively cooling down and thereby losing its fluid characteristics. Particularly at or close to injection locations where the polymer is injected into the cavity and then impacts onto the prearranged PV label, excessive forces may be exerted on the solar cells comprised within the PV label and may induce cell breakage. In contrast hereto, with the compression moulding approach described herein, the viscous polymer mass is applied to the rear surface of the PV label inside the cavity with a low pressure, thereby limiting the forces acting on the solar cells in the PV label. After having disposed a depot of polymer mass in this way, the polymer mass is then distributed along the rear surface of the PV label by pushing the movable moulding half towards the fixed moulding half of the moulding device and thereby successively closing the moulding device and reducing the volume of the cavity enclosed between the moulding halves of the moulding device.

In this way, the polymer mass is spread throughout the cavity with relatively low pressures and, particularly, with a homogeneous pressure distribution, i.e. without excessive local pressure peaks. Accordingly, the risk of cell breakage may be significantly reduced and, after the polymer mass has solidified upon e.g. sufficiently cooling down, the intact PV label together with the support structure formed by the solidified polymer mass may be removed from the moulding device.

In the following, possible features of embodiments of the invention and associated possible advantages will be described in more detail.

The approach proposed herein is particularly suitable for a PV-integrated (car body or other, as a panel for buildings or the like) panel comprising multiple PV cells which are prepared based on brittle semiconductor wafers. The PV cells may be, for example, solar cells being fabricated based on crystalline silicon wafers. Such wafer-based Si-PV cells may generally have e.g. a high efficiency of more than 15% (i.e. e.g. between 17% and 26%) and a high reliability. Furthermore, well established industrial processes exist for their fabrication. Such PV cells typically have lateral dimensions of between 50x50 mm² and 300x300 mm², mostly between 150x150 mm² and 200x200 mm², with a square shape, a rectangular shape, a round shape, a semi-round shape or any other shape. Furthermore, such PV cells generally have a thickness of more than 50 µm, typically between 100 µm and 300 µm.

Having such thickness, the PV cells are relatively rigid, i.e. they may generally not be bent into small bending radii of e.g. less than their lateral dimensions. Generally, it may be assumed that, depending on a cell size, bending radii of less than 80 cm, less than 90 cm or less than 100 cm should be avoided.

Each PV cell comprises electric contacts. The electric contacts of neighbouring PV cells may be interconnected via electrical connections such that these PV cells may be electrically connected in series, in parallel or in any combination of series and parallel connections. The electrical connections may be provided by one or more electrically conducting ribbons and/or one or more copper solderings between two adjacent photovoltaic cells, preferably between each two adjacent photovoltaic cells of a respective string. A plurality of interconnected PV cells forms part of a solar cell arrangement, sometimes also referred to as solar cell string. The solar cell arrangement may further comprise additional components such as external contacts via which the solar cell arrangement may be connected to an external electric circuit, such external contacts sometimes being referred to as forming part of a junction box or connection box. Furthermore, the solar cell arrangement may comprise for example bypass diodes or other electric components. Additionally, one or more release loops for releasing mechanical tensions may be included in the solar cell arrangement.

The solar cell arrangement is generally comprised in an encapsulation into which the solar cells, the electrical interconnections and possibly other components are embedded. Typically, the encapsulation comprises or consists of a thermoplastic polymer such as EVA (Ethylene Vinyl Acetate) or POE (Polyolefin Elastomer). The encapsulation may be composed of a front side polymeric lamination foil and a rear side polymeric lamination foil enclosing the plurality of solar cells from opposite sides. The lamination foils may also be referred to as encapsulation foils. In a lamination procedure, such front and rear side encapsulation foils may then be heated beyond a glassifying temperature of the polymeric material while being pressed against each other. Accordingly, the sticky viscous or even partially molten polymer material of both encapsulation foils may combine in regions where the foils contact each other and/or may glue to solar cells interposed between the encapsulation foils. Accordingly, upon cooling down and solidifying the polymer material, the solar cells and the polymer material of the lamination foils may form an encapsulation.

As the solar cell arrangement in its encapsulation is generally very fragile, the solar cell arrangement including the solar cells, the electric connections and the encapsulation is reinforced by one or more stabilisation foils for forming a PV label. Preferably, a front side polymeric stabilisation foil and a rear side polymeric stabilisation foil may enclose the interposed solar cell arrangement and may form a substrate and a superstrate, respectively, prior to reinforcing the PV label by moulding the support structure. In specific embodiments, the PV label may not necessarily comprise the rear side polymeric stabilisation foil. The one or more polymeric stabilisation foils may have a thickness of typically between 250µm and 2500µm. Each of the foils may adjoin and/or cover a part or an entirety of one of opposing surfaces of all of the PV cells. The polymeric stabilisation foils may be made with various polymeric materials such as, polycarbonate (PC), polyethylenterephthalat (PET), polyamide (PA), polyetheretherketone (PEEK), Acrylonitrile butadiene styrene (ABS), Polymethyl methacrylate) (PMMA), Polyvinylchlorid (PVC) or a mix of them. At least the front side stabilisation foil as well as the front side lamination foil shall consist of an optically translucent or transparent material. Particularly, a material forming the stabilisation foil may be a thermoplastic material, i.e. a material which becomes plastic or viscous upon being heated to elevated temperatures. The front and rear side polymeric stabilisation foils may enclose the interposed solar cell arrangement and, upon being joined with each other, encapsulate the solar cell arrangement. Optionally, glass fiber reinforced or carbon fibre reinforced plastics may be included between the polymeric foils.

Particularly, the front side polymeric stabilisation foil, the rear side polymeric stabilisation foil and the PV cells may be joined together by an application of heat and/or a lamination process. In other words, after having arranged e.g. the rear side polymeric stabilisation foil, the solar cell arrangement with its encapsulation and finally the front side polymeric stabilisation foil on top of each other in a loose manner, these stacked layers may be interconnected by mechanically joining with each other. Such joining may be induced for example by applying sufficient heat to the stack such that the polymeric material of the polymeric foils becomes viscous and/or sticky. Accordingly, upon such temporary application of heat, the polymeric stabilisation foils may mechanically interconnect with each other and/or with the interposed solar cell arrangement.

Thus, the front and rear side polymeric stabilisation foils and the solar cell arrangement are joined in a lamination procedure. The lamination procedure may be integral with the lamination procedure used for forming the encapsulation embedding the PV cells, i.e. both the front and rear side polymeric stabilisation foils as well as the front and rear side polymeric encapsulation foils may be glassified or partially molten within a single lamination step. Alternatively, two separate lamination steps may be performed, i.e., first, the solar cell arrangement is laminated with the encapsulation foils enclosing the PV cells and, then, the PV label is laminated with the stabilisation foils enclosing the solar cell arrangement in between. As a result of such lamination procedure, the front and rear side polymeric foils and, optionally, also the PV cells are integrally joined with each other in a positive substance jointing. However, the lamination procedure may alternatively or additionally include other measures for joining the polymeric foils such as for example applying a glue or adhesive at an interface between the polymeric foils and/or at an interface between one of the polymeric foils and the solar cell arrangement.

The entire PV label may have a thickness in a range of between 0.5 mm to 10 mm, typically between 0.5 mm to 5 mm or between 1 mm and 3 mm. Lateral dimensions of the PV label may range from about 0.1 m to 4 m, typically from 0.2 m to 2 m. The PV label may be flexible and bendable and may be formed into an arbitrary contour being adapted e.g. to a shape of the intended car body panel. Therein, the solar cells comprised in the car body panel cover a substantial portion, i.e. for example more than 30%, preferably more than 50% or even more than 70%, of an outer surface of the car body panel.

The PV label is generally flexible, bendable and/or, at least in some applications, not sufficiently self-supporting. Accordingly, for forming a self-supporting PV panel, the PV label generally has to be reinforced by a support structure. Such support structure typically has a higher mechanical stability than the PV label. Such higher mechanical stability may result, inter-alia, from larger geometrical dimensions such as a larger thickness compared to the thickness of the PV label and/or higher stiffness due to material properties of the polymer used. The support structure and the PV label are generally mechanically interconnected such that forces acting onto the PV label may be transmitted to the support structure and vice versa.

According to the approach described herein, the support structure shall be prepared with a viscous mouldable polymer using an injection compression moulding technique.

Such a technique may be implemented with a moulding device in accordance with an embodiment of the second aspect of the invention. Such moulding device may also be referred to as compression moulding device or injection compression moulding device.

It generally comprises two moulding halves which may be displaced relative to each other between an open state and a closed state. One moulding half is referred to as core side moulding half, the other one as cavity side moulding half. In the open state, the two moulding halves are arranged with a distance from each other, i.e. there is a gap between the moulding halves. The distance may be at least some millimeters. Particularly, the distance should be large enough to initially insert the PV label between the two moulding halves and, upon completion of the compression moulding procedure, remove the final PV panel from between the two moulding halves. Starting from this open, spaced state, the moulding halves may be displaced towards each other in order to come to the closed state. For such purpose, the moulding device may have an actuator arrangement including e.g. one or more electromotors, hydraulics, pneumatics, etc. with which one or both of the moulding halves may be displaced. In the closed state, the two moulding halves are in tight contact with each other at least along a rim of the moulding halves. Both moulding halves have surfaces directed to each other, these surfaces being enclosed by the rim and being therefore referred to herein as inner surfaces. These inner surfaces have a contour such that a cavity is enclosed between the opposing surfaces upon the moulding halves being in the closed state. At least one of such inner surfaces has a generally concave contour, whereas the other one of the inner surfaces may have a generally concave contour or a generally convex contour. Therein, the inner surfaces are contoured such that the enclosed cavity generally has the intended form of the PV panel to be produced. Particularly, the inner surfaces as well as the surfaces of the resulting PV panel may have a curved contour with curvatures being present in one or two directions.

Furthermore, the moulding device comprises a fixation arrangement. This fixation arrangement is specifically configured for temporarily fixing the sheet-like photovoltaic label to the core side moulding half in a way such that the PV label abuts or is adjacent to at least a partial area of its front side to at least a partial area of the inner surface of the core side moulding half. In such a fixed or pre-fixed state, the rear side of the PV label is directed to the surface of the cavity side moulding half. It is noted that if the configuration of the moulding halves is vice versa the PV label may also be directed to the surface of the other moulding half, in this case, the core side moulding half.

However, at least partial areas of the rear side surface of the PV label are spaced apart from the surface of the cavity side moulding half via interposed portions of the cavity. Generally, the fixation arrangement shall be configured for fixing the PV label such that the PV label may withstand forces applied to it during the injection compression moulding procedure. Furthermore, the PV label shall be fixed in a reversible manner in order to enable simple removal of the final product, i.e. the final PV panel, from the moulding device after completion of the moulding procedure. Additionally, the fixation arrangement shall be configured so as to enable fixing the PV label without damaging the fragile solar cells enclosed therein. Possible implementations of such fixation arrangement are described in another patent application filed by the applicant concurrently with the present application, the disclosure of which being incorporated herein in its entirety by reference.

As a further feature, the moulding device comprises an injection arrangement. This injection arrangement is configured for injecting a viscous polymer mass into the cavity between the moulding halves. Specifically, the injection arrangement shall inject the polymer mass towards the rear surface of the PV label being arranged between the moulding halves. For such purpose, the injection arrangement may comprise one or more nozzles and/or ducts arranged at one or more injection locations along the inner surface of the cavity side moulding half. The nozzles and/or ducts may be supplied with the polymer mass using one or more pumps, conveyors, a screw inside a barrel, or similar devices, wherein the polymer mass may be stored for example in a polymer reservoir. Optionally, the injection arrangement may include a heater arrangement for heating the polymer mass to an elevated temperature at and/or before its injection into the cavity. Therein, the injection arrangement may be configured to start injecting the polymer mass already before the moulding halves have been displaced to the closed state. Particularly, the injection arrangement may inject the polymer mass with a relatively low pressure inside the cavity. The injection pressure may be limited to an extent where forces applied to the PV label are small enough to reliably prevent any solar cell breakage. At such low injection pressures, the polymer mass initially injected into the cavity will generally not fill the entire cavity, i.e. will not flow along the entire rear side of the PV label and into each and every partial volume of the cavity, but, instead, will form a locally limited depot of polymer mass. Such polymer mass depot may then be distributed along the entire surface of the PV label upon the moulding halves being pushed towards each other when closing the moulding device, thereby successively reducing the volume of the cavity between the moulding halves.

Referring to the method according to the first aspect of the invention, in order to produce the PV panel with the injection compression moulding device, a support structure is prepared at a rear side of a PV label using an injection compression moulding procedure. Therein, the PV label is first arranged between the two moulding halves and is fixed to at least one of the moulding halves, preferably to the core side moulding half, using the fixation arrangement while the moulding device being in its open state. Preferably, the PV label is arranged in the cavity between the two moulding halves such that a front surface of the PV label abuts to the inner surface of the core side moulding half and the rear surface of the PV label is directed to the inner surface of the cavity side moulding half. Subsequently, at least some volume of the viscous polymer mass is injected by the injection arrangement to the rear surface of the PV panel while the moulding device is still in its open state or at least while the moulding device not yet being in its fully closed state. Then, the moulding device is closed to its closed state by pushing the moulding halves towards each other. As a result of such pushing action, the cavity between the moulding halves and the polymer mass disposed therein are successively compressed. Due to such compression, the viscous polymer mass starts to flow into partial volumes of the cavity which previously have not been occupied by the polymer mass depot, i.e. the polymer mass will distribute along the rear surface of the PV label until the compressing cavity is completely filled. After having reached the fully closed state, the moulding device is kept in such a state until the injected polymer mass is at least partly solidified. For example, such solidification may occur upon the polymer mass being a thermoplastic polymer and being cooled down below a plastification temperature. Alternatively the polymer mass may in principle also be a thermosetting polymer and the solidification may occur upon e.g. chemical reactions progressing throughout the polymer. After having reached a sufficient degree of solidification, the polymer mass forms the support structure for the PV label and the moulding device may be opened again by opening the mould. Finally, the PV label with the support structure attached thereto may be removed from the moulding device and may form the PV panel as the final production product.

According to an embodiment, the core side moulding half and a cavity side moulding half are configured such that, in the closed state of the moulding device, the cavity is formed such that the inner surface of the cavity side moulding half is spaced apart from the rear surface of the photovoltaic label by at least 0.5 mm, preferably at least 1 mm or at least 2 mm, at least in a partial area of the photovoltaic label in which the photovoltaic label encloses the solar cell arrangement.

In other words, the opposing inner surfaces of both moulding halves may have a contour such that the cavity formed thereby upon the moulding device being in its fully closed state has dimensions which are large enough such as to enable the rear side of the PV label to be spaced apart from the inner surface of the cavity side moulding half. Expressed differently, even in the fully closed state, the cavity has an inner diameter or gap which is larger than the thickness of the PV label such that, even with the PV label being arranged within the cavity, there remains some hollow partial volume of the cavity at the rear side surface of the PV label, i.e. there remains a gap between the rear side surface of the PV label and the inner surface of the cavity side moulding part. Such hollow partial volume or gap may then be used to spread the polymer mass depot previously deposited onto the rear side surface of the PV label along the rear surface of the PV label upon the moulding halves being pushed towards each other into the enclosed state. Particularly, the hollow partial volume or gap shall preferably extend along the entire partial area of the PV label in which the PV label encloses the solar cell arrangement. In other words, even in the closed state of the moulding device, no portion of the inner surface of the cavity side moulding half shall come into direct contact and press onto the partial area of the PV label enclosing the solar cell arrangement. Accordingly, due to such lacking direct contact, no excessive forces or even local force peaks may act onto the solar cells comprised in the solar cell arrangement. Instead, any forces exerted upon the moulding halves being pushed together act onto the viscous polymer mass in the cavity and are thereby homogeneously distributed along the surface of the PV label. Accordingly, a risk of solar cell breakage may be minimised.

Furthermore, as the distance or gap between the rear side surface of the PV panel and the opposing inner surface of the cavity side moulding half shall be at least 0.5 mm, any direct contact between both surfaces may even be prevented in cases where the PV panel shows for example thickness variations along its lateral extension, as long as such thickness variations are smaller than the indicated distance or gap. Accordingly, even though the PV label may have some thickness variations along its lateral extension resulting for example from manufacturing tolerances with regards to the thicknesses of the various layers comprised therein, thicker local portions of the PV label will not suffer from a substantial locally increased pressure during the injection compression moulding procedure.

According to a further specified embodiment, the viscous polymer mass is injected such that and the two moulding halves are configured such that and pushed together such that the injected polymer mass is distributed along the rear surface of the photovoltaic label such as to form a continuous layer abutting to the photovoltaic label at least in a partial area of the photovoltaic label in which the photovoltaic label encloses the solar cell arrangement.

Expressed differently, the contour of the inner surfaces of the moulding halves and the cavity formed thereby may be configured such that, upon polymer mass being injected into the cavity and the cavity then being compressed upon the moulding device being displaced to its closed state, the polymer mass may spread along the entire rear surface of the PV label. Due to such spreading, the polymer mass may form a continuous layer, i.e. a layer having no interruptions. In other words, the polymer mass may abut to and cover the entire partial area of the PV label enclosing the solar cell arrangement. Accordingly, during the injection compression moulding procedure, the polymer mass may distribute forces applied upon the moulding halves being pushed together, thereby preventing excessive forces or local force peaks which otherwise could induce solar cell breakage. Furthermore, in the final PV panel, the continuous layer of solidified polymer mass may protect the entire rear side surface of the PV label at least in the partial area enclosing the solar cell arrangement, thereby, inter-alia, protecting the solar cells against mechanical influences such as forces locally pressing onto the rear side of the PV panel.

According to an embodiment, the viscous polymer mass is injected at multiple locations distributed along the rear surface of the photovoltaic label.

Expressed differently, the polymer mass may not only be injected into the cavity at a single injection location, i.e. with e.g. a single injection nozzle, but may be injected at multiple injection points or locations using e.g. multiple injection nozzles. Therein, the injection locations may be distributed along the rear surface of the PV label, i.e. may be spaced apart from each other in directions along the inner surface of the cavity sides moulding half. Due to such distributed injection, the injected polymer mass depot may be spread along the rear surface of the PV label. For example, instead of a single polymer mass depot being generated at a centre of the rear side surface of the PV label with a significant depot thickness, multiple smaller polymer mass depots may be disposed at multiple locations on the rear side of the PV label. Accordingly, upon closing the moulding device, the compression of the cavity may act on the multiple smaller and distributed polymer mass depots, thereby spreading the exerted forces along a larger partial area of the PV label. Thereby, excessive local pressures or pressure peaks may be avoided, again possibly lowering the risk of solar cell breakage.

According to an embodiment, upon preparing the support structure, injecting the viscous mass may be started before closing the moulding device.

In other words, at least a partial volume of the overall polymer mass volume required for generating the support structure may be injected towards the cavity of the moulding device and thereby disposed at the rear surface of the PV label already while the moulding device is in its open state. In such an open state, the viscous polymer mass may be injected with relatively low pressures.

Additionally or alternatively, according to an embodiment, the viscous polymer mass may be injected during closing the moulding device.

Thus, at least a partial volume of the overall polymer mass volume required for generating the support structure may be injected towards the cavity of the moulding device and thereby disposed on the rear surface of the PV label while the moulding device is currently closed from its open state towards its closed state but is not yet fully closed. In such an intermediate state, the viscous polymer mass may be injected with relatively low pressures while, at the same time, being also distributed along the surface of the PV label as a result of the cavity being successively compressed during the closing action of the moulding device. By injecting at least a part of the polymer mass during such closing action, an overall processing time may be shortened.

According to an embodiment, at an initial stage of the injection procedure, the viscous polymer mass is injected at a first number of injection locations, and, at a later stage of the injection procedure, the viscous mass is injected at a second number of injection locations including injection locations other than the injection locations included in the first number of injection locations.

In other words, the injection procedure may be initiated by injecting some polymer mass via a single nozzle or a few nozzles at a first injection location or a few first injection locations. The first number of injection locations may be arranged for example at or close to a centre of the inner surface of the cavity side moulding half. Accordingly, one or more polymer mass depots may initially be disposed centrally within the cavity of the moulding device. Then, at a later stage of the injection procedure, i.e. for example upon the moulding halves having been already at least partly closed and thereby the polymer mass depots having been already partly distributed, some further polymer mass may be injected via one or more other nozzles at a second injection location or a few second injection locations. The second number of injection locations may be spaced apart from the first number of injection locations and may be arranged for example close to a circumference of the inner surface of the cavity side moulding half. At the later stage of the injection procedure, polymer mass may be injected at the second number of injection locations additionally or alternatively to injecting polymer mass at the first number of injection locations. Overall, by varying the number and/or position of injection locations during the injection procedure, a distribution of injected polymer mass may be accelerated and/or may be made more homogeneous.

According to an embodiment, the viscous polymer mass may be injected with a pressure of less than 4000 bar, in particular, the injection pressure may be in a range between 1000 and 3000 bar. It is noted that the closing pressure of the moulding device, preferably less than 6000 tons or even less than 4000 tons, and most preferably about 2500 tons.

Thus, by using the injection compression moulding technique as described herein, substantially lower injection pressures may be applied as compared to conventional injection moulding techniques. Such reduced pressures support avoiding solar cell breakage in the PV label.

According to an embodiment, the polymer mass comprises a polymer configured to at least one of adhering and forming a positive substance joining with the polymer of a rear-most one of the rear side polymeric lamination foil and the optional rear side polymeric stabilisation foil.

Generally, there is a multiplicity of polymer materials which may be processed with moulding techniques. In many cases, a type of polymer material used for preparing a component is selected based on requirements defined for the specific component, i.e. for example a rigidity, a mechanical loadability, thermal characteristics, chemical characteristics, etc. to be fulfilled for the specific component. In the application of preparing a PV panel as described herein, an additional requirement has to be fulfilled, namely that the support structure formed by the moulding technique should reliably be fixed to the PV label to be supported thereby. For such purpose, a polymer material should be used in the moulding technique which polymer material may strongly adhere or even form a positive substance jointing with the polymer to which it has direct contact upon being applied to the rear side surface of the PV label, i.e. to the polymer of the rear side polymeric lamination foil or, if present, the polymer of the rear side polymeric stabilisation foil.

Particularly, according to an embodiment, the polymer mass may comprise a blend of acrylonitrile butadiene styrene (ABS) and polycarbonate (PC).

It has been found that a PV label may be beneficially provided with a polymeric foil at its rear side being made of polycarbonate. In order to enable good adherence or even a positive substance joining to the PV label, it may therefore be beneficial to use polycarbonate as a polymer material in the moulding procedure. However, it has been found that using pure polycarbonate may pose some problems during the moulding procedure. For example, moulding polycarbonate may require high pressures due to its high viscosity and/or high processing temperatures. Accordingly, it has been found that at least some of these problems may be relaxed by blending the PC polymer material by adding some ABS polymer material. Such blend, for example, may comprise for example between 70-95% PC and between 5-30% of ABS or other. For example, Bayblend T85X may be used which comprises 85% PC and 15% ABS.

It shall be noted that possible features and advantages of embodiments of the invention are described herein partly with respect to a method of producing a PV panel and partly with respect to a moulding device for implementing such method. One skilled in the art will recognize that the features may be suitably transferred from one embodiment to another and features may be modified, adapted, combined and/or replaced, etc. in order to come to further embodiments of the invention.

### BRIEF DESCRIPTION OF THE DRAWINGS

In the following, advantageous embodiments of the invention will be described with reference to the enclosed drawings. However, neither the drawings nor the description shall be interpreted as limiting the invention.
Fig. 1 shows a top view of a PV panel in accordance with an embodiment of the present invention.
Fig. 2 shows a sectional view of the PV panel along the line A-A in Fig. 1.
Fig. 3 shows a sectional view of a PV label.
Fig. 4 shows a sectional view of a moulding device according to an embodiment of the present invention in an open state.
Fig. 5 shows a sectional view of the moulding device of Fig. 4 in a closed state.
Fig. 6 shows a perspective view onto a core side moulding half of a moulding device according to an embodiment of the present invention.
Fig. 7(a) - (c) visualises a sequence of an injection and distribution of a viscous polymer mass during an injection compression moulding procedure in accordance with an embodiment of the present invention.

The figures are only schematic and not to scale. Same reference signs refer to same or similar features.

### DESCRIPTION OF PREFERRED EMBODIMENTS

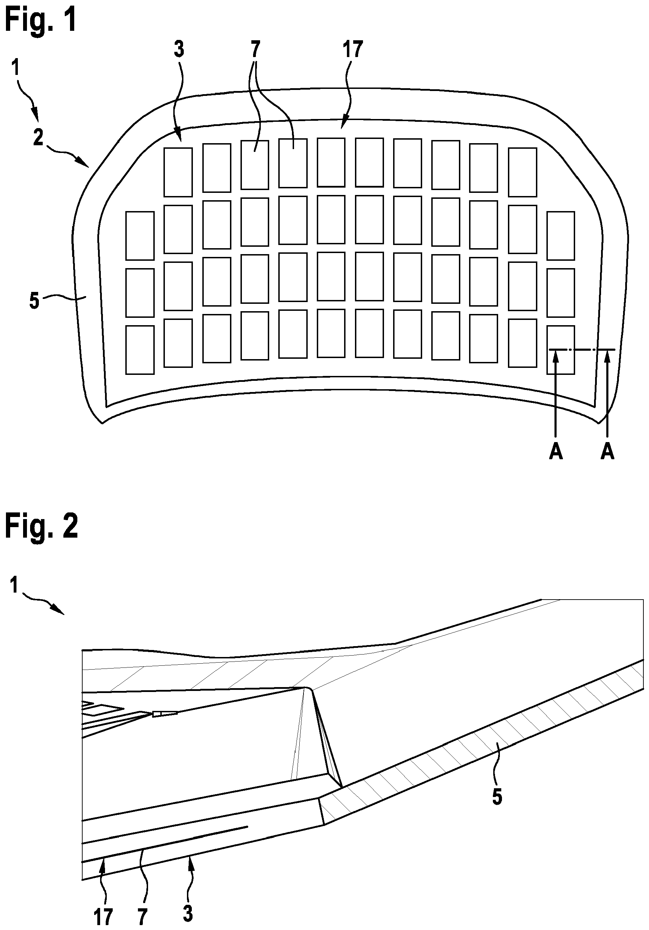

Fig. 1 shows a top view of a PV panel 1 which may be produced in accordance with the method described herein. Fig. 2 shows a sectional view along the line A-A indicated in Fig. 1.

The PV panel 1 comprises a sheet-like PV label 3 supported by a support structure 5. In this specific example, the PV panel 1 is embodied as a PV car body panel in the form of a car hood 2. The PV panel 1 forms a portion of a car body structure and comprises a curved geometry in accordance with a curved design of such a car body structure. The PV label 3 is incorporated into the PV panel 1 with its solar cells 7 being part of a solar cell arrangement 17 embedded in the PV panel 3 and being arranged at an outer surface of the hood 2, such outer surface being at least slightly curved in two dimensions. The sheet-like PV label 3 has a thickness of about 2 mm to 4 mm and is supported at its rear side and at its circumference by the support structure 5 being made with a mouldable polymer material and having a thickness of typically about 1 mm to 5 mm. The thickness of the PV label 3 may slightly vary along its lateral extension, e.g. due to manufacturing tolerances, such variations typically being in a range of up to 20% relative to the mean thickness or up to 0.5 mm or even up to 1 mm absolute. The thickness of the support structure may vary along its lateral extension, e.g. due to different local mechanical requirements to be fulfilled by the support structure.

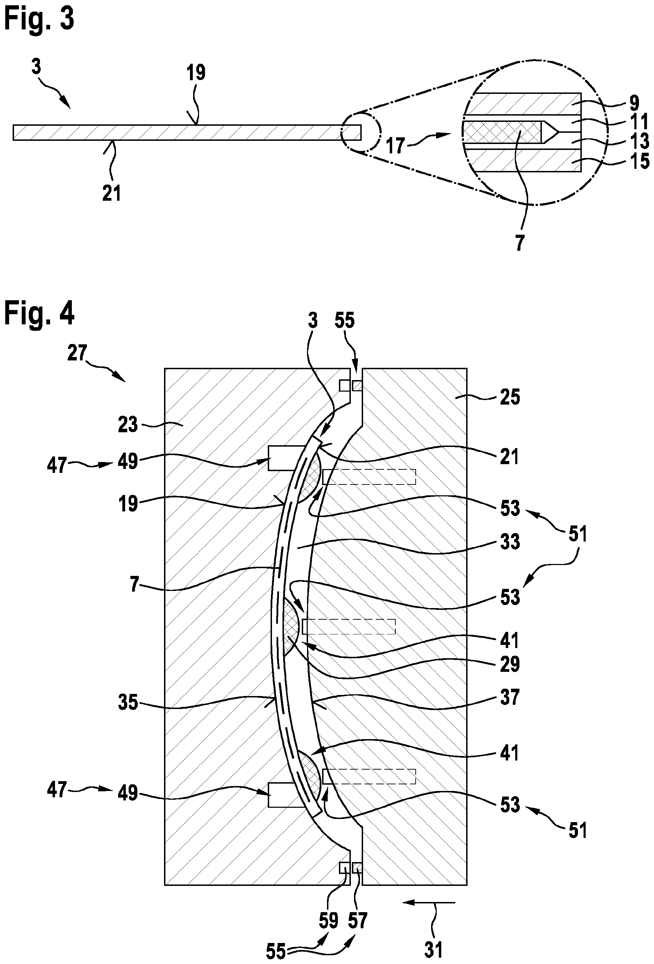

Fig. 3 shows a sectional view of an exemplary PV label 3 with a front surface 19 and a rear surface 21. The PV label 3 comprises a front side polymeric stabilisation foil 9, a front side polymeric lamination foil 11, a rear side polymeric lamination foil 13 and a rear side polymeric stabilisation foil 15. Furthermore, a solar cell arrangement 17 comprises multiple wafer-based solar cells 7 interposed between the front and rear side lamination foils 11, 13 of the PV label 3 and interconnected with each other. The various foils 9, 11, 13, 15 and the solar cell arrangement 17 are laminated such as to form an integral stack in which the fragile solar cells 7 are supported and protected e.g. against an impact of excessive external forces and/or bending forces.

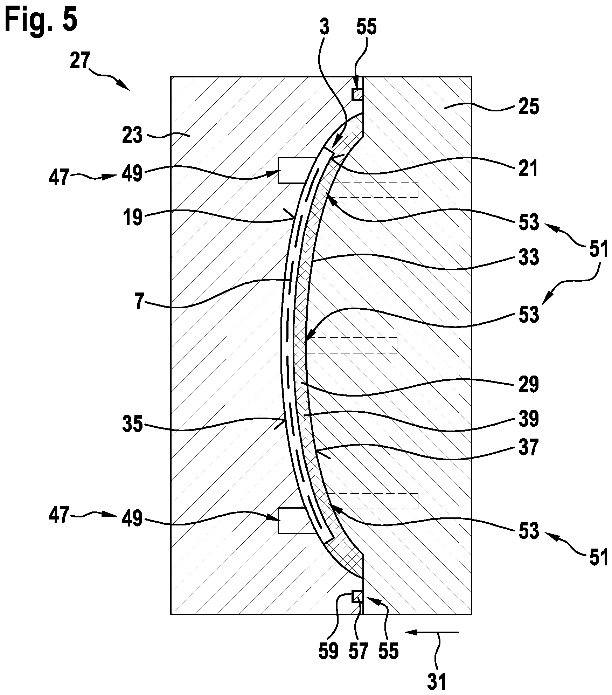

Fig. 4 and Fig. 5 show cross sectional views of a moulding device 27 in an open state and a closed state, respectively, of the moulding device 27. The moulding device 27 is specifically adapted for producing a PV panel 1 in accordance with the method described herein.

The moulding device 27 comprises a moving side moulding half which in this embodiment is the core side moulding half 23 and a fixed side moulding half which in this embodiment is the cavity side moulding half 25. The two moulding halves 23, 25 are displaceable relative to each other in a displacement direction 31, or vice versa depending on which one of the moulding halves is the moving side and the fixed side moulding half, from the open state shown in Fig. 4 to the closed state shown in Fig. 5, or vice versa. The moulding halves 23, 25 comprise opposing inner surfaces 35, 37.

Therein, the inner surface 35 at the core side moulding half 23 and the inner surface 37 at the cavity side moulding half 25 are formed such that, even in the closed state of the moulding device 27, there remains enough volume in between both inner surfaces 35, 37 such as to form a cavity 33. A thickness of this cavity 33 is larger than a thickness of the PV panel 3. Accordingly, even when the moulding device 27 is fully closed and the PV panel 3 is comprised in the cavity 33, there remains an empty volume in the cavity 33. In this empty volume, a polymer mass 29 may be generated, as describes in detail further below, such as to form the support structure 5 supporting the PV label 3.

The moulding device 27 further comprises a fixation arrangement 47. This fixation arrangement 47 is configured for temporarily fixing the PV label 3 at the core side moulding half 23 such that its front surface 19 abuts to the inner surface 35 of this core side moulding half 23. Upon being fixed in such manner, the rear surface 21 of the PV label 3 is directed to the inner surface 37 of the cavity side moulding half 25 but is spaced from this inner surface 37 via the interposed remainder of the cavity 33. In the example shown, the fixation arrangement 47 comprises multiple suction devices 49. Such suction devices 49 may generate an underpressure such as to suck the PV label 3 towards the inner surface 35 of the core side moulding half 23, thereby reliably fixing the PV label 3. Possible details of the fixation arrangement 47 are described in a parallel patent application filed concurrently with the present application.

Furthermore, the moulding device 27 comprises an injection arrangement 51. This injection arrangement 51 is configured for injecting the viscous polymer mass 29 into the cavity 33 towards the rear surface 21 of the PV label 3. In the example shown, the injection arrangement 51 comprises several nozzles 53 via which the polymer mass 29 may be injected and/or pressed into the cavity 33. The nozzles 53 are arranged at a plurality of injection locations 41 throughout the cavity 33.

Finally, the moulding device 27 comprises an engagement arrangement (only visualised in a very schematic manner) via which the displacement motion of the two moulding halves 23, 25 relative to each other may be precisely guided. In the example shown, this engagement arrangement 55 comprises protrusions 57 at the cavity side moulding half 25 close to a circumference around its inner surface 37 and complementary recessions 59 at the core side moulding half 23 close to its circumference around the inner surface 35.

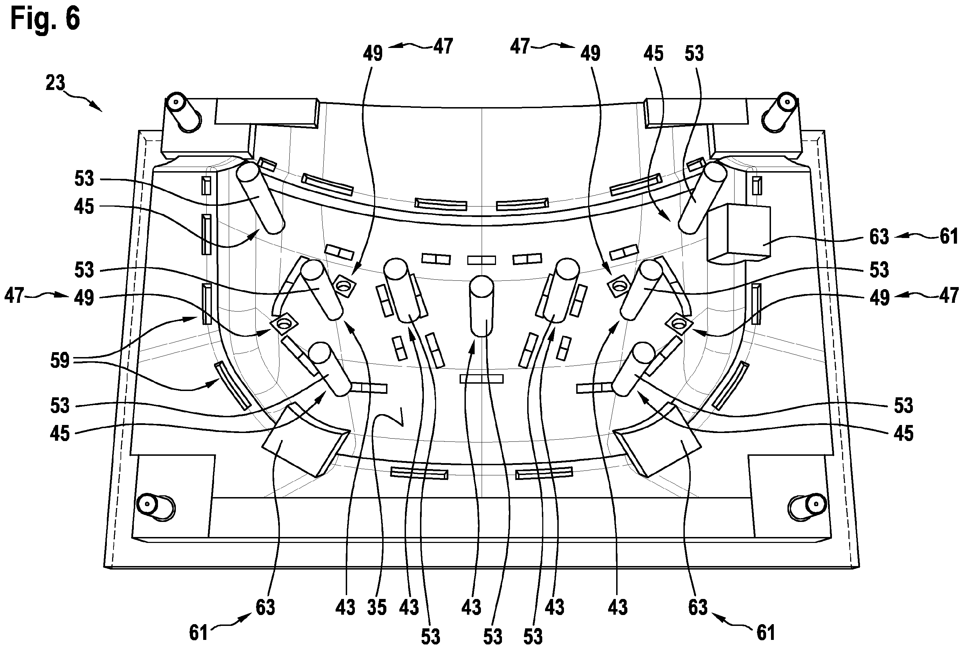

Fig. 6 shows a perspective view onto the inner side of the core side moulding half 23. In this visualisation, also the nozzles 53 of the injection arrangement 51 coming from the cavity side moulding half 25 are depicted. Therein, nine nozzles 53 are arranged at different injection locations, wherein five of the nozzles 53 are arranged at first injection locations 43 centrally within the inner surface 35 of the core side moulding half 23, whereas four nozzles 53 are arranged at second injection locations 45 at a periphery, i.e. close to the circumference, of the inner surface 35.

Furthermore, Fig. 6 shows some brackets 63 of a positioning arrangement 61 which may be used for pre-positioning the PV label 3 at the core side moulding half 23 in an intended position relative to the inner surface 35, before subsequently fixing the PV label 3 using the fixation arrangement 47.

Next, a sequence of steps of an embodiment of a method for producing a PV panel 1 is described.

The PV label 3 may be produced in a preceding separate production procedure, in which the various stabilisation foils 9, 15 and lamination foils 11, 13 with the solar cell arrangement 17 being interposed are laminated to form a stack, which may then be handled as a unit.

The PV label 3 is then arranged between the two moulding halves 23, 25 upon the moulding device 27 being in its fully open state. Initially, the moulding halves 23, 25 may be arranged such as to be widely spaced from each other by several centimetres, thereby enabling an easy access to the volume between both moulding halves 23, 25. First, the PV label 3 may be put into the brackets 63 of the positioning arrangement 61. Subsequently, the PV label 3 originally being in a planar configuration may be slightly pressed into the curved inner surface 35 of the core side moulding half 23 such as to abut with its front surface 19 to the inner surface 35. In such configuration, the suction device 49 of the fixation arrangement 47 may then fix the PV label 3.

Subsequently, the moulding halves 23, 25 may be displaced from their widely opened state towards a less widely opened state in which they are spaced from each other only by a few millimetres, for example between 5 and 6 mm. This state is represented in Fig. 4.

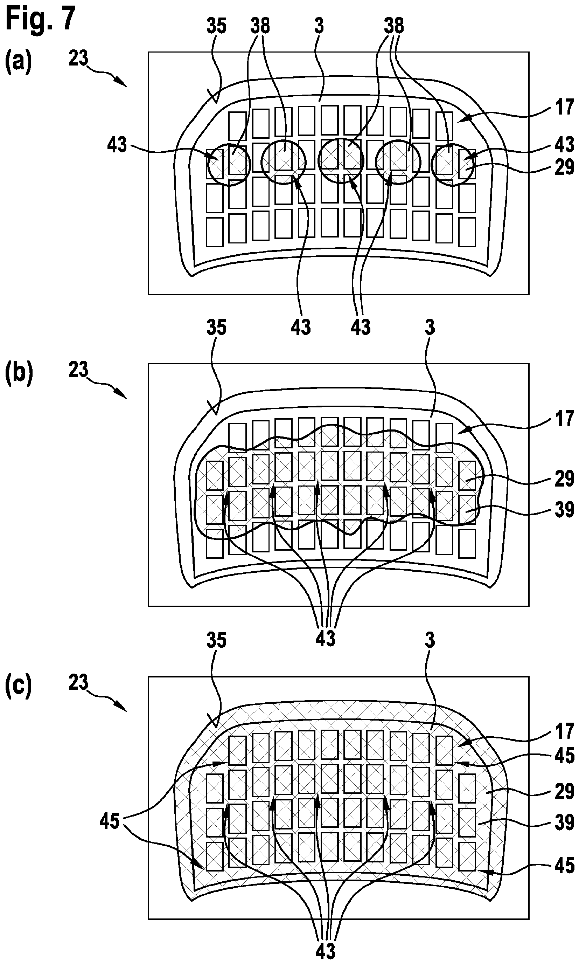

In such a slightly opened state, the injection procedure may then be initiated. As visualised in Fig. 7, such injection procedure may include several substeps.

In a first substep, as shown in Fig. 7(a), viscous polymer mass 29 is injected at various first injection locations 43 centrally arranged with regards to the inner surface 35 of the core side moulding half 23 and the PV panel 3 fixed thereto. In the example shown, polymer mass 29 is injected through five central nozzles. Accordingly, various polymer mass depots 38 are formed at the first injection locations 43. Such first substep may be executed for e.g. about 2 seconds. During this initial substep, the moulding device 27 is held in its slightly opened state.

In a second substep, as shown in Fig. 7(b), the two moulding halves 23, 25 are successively displaced towards each other by removing the moving side or core side moulding half 23 from the fixed side or cavity side moulding half 25 in order to close the moulding device 27. In the meantime, polymer mass 29 is continuously supplied and injected via the nozzles at the first injection locations 43. Such a second substep may take e.g. between 1.5 and 2 seconds.

In a third substep, as shown in Fig. 7(c), the two moulding halves 23, 25 are already at or at least shortly before their fully closed state, as shown in Fig. 5. At this stage, polymer mass 29 may also be supplied and injected via nozzles at the second injection locations 45 at the periphery of the inner surface 39 of the core side moulding half 23. Such a third substep may be significantly shorter than the preceding substeps and may take e.g. between 0.2 and 0.5 seconds.

During the second and third substep and as a result of the closing action established during these substeps, the space between the opposing inner surfaces 35, 37 of the two moulding halves 23, 25 becomes successively narrower, i.e. the cavity 33 becomes shallower, and the polymer mass depots 38 therefore become compressed and spread laterally along the rear surface 21 of the PV label 3. As the inner surface 37 of the cavity side moulding half 25 is designed such as to be spaced apart from the rear surface 21 of the PV label 3 fixed to the inner surface 35 of the core side moulding half 23 by at least 0.5 mm, preferably between 1 mm and 5 mm, a continuous layer 39 of polymer mass 29 may form at the rear surface 21 of the PV label 3. This continuous layer 39 is formed at least in a partial area of the PV label 3 in which the PV label 3 encloses the solar cell arrangement 17. At the end of the third substep, the continuous layer 39 of polymer mass 29 extends along the entire rear surface 21 of the PV label 3 and even at least slightly beyond its lateral edges.

The polymer mass 29 being injected during the injection and compression procedure and finally forming the continuous layer 39 of polymer mass 29 may then solidify as a result of e.g. a cooling process and/or a chemical reaction process. After such solidification, the polymer mass 29 forms the support structure 5 for the PV panel 1. Accordingly, the moulding device 29 may be opened by pulling the moulding house 23, 25 away from each other to bring the moulding device 27 in its fully open state and the final PV panel 1 including the PV label 3 with the support structure 5 attached thereto may finally be removed from the moulding device 27.

Finally, it should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims.

### LIST OF REFERENCE SIGNS

- 1: PV panel
- 2: hood
- 3: PV label
- 5: support structure
- 7: solar cell
- 9: front side polymeric stabilisation foil
- 11: front side polymeric lamination foil
- 13: rear side polymeric lamination foil
- 15: rear side polymeric stabilisation foil
- 17: solar cell arrangement
- 19: front surface
- 21: rear surface
- 23: core side moulding half
- 25: cavity side moulding half
- 27: moulding device
- 29: polymer mass
- 31: displacement direction
- 33: cavity
- 35: inner surface of core side moulding half
- 37: inner surface of cavity side moulding half
- 38: polymer mass depot
- 39: continuous layer of polymer mass
- 41: injection location
- 43: first injection location
- 45: second injection location
- 47: fixation arrangement
- 49: suction device
- 51: injection arrangement
- 53: nozzle
- 55: engagement arrangement
- 57: protrusion
- 59: recession
- 61: positioning arrangement
- 63: bracket

## Claims

1. Method for producing a photovoltaic panel (1), particularly a photovoltaic vehicle body panel, the method comprising:
providing a photovoltaic label (3) comprising a front side polymeric stabilisation foil (9), a front side polymeric lamination foil (11), a rear side polymeric lamination foil (13) and, optionally, a rear side polymeric stabilisation foil (15) as well as a solar cell arrangement (17) interposed between the front and rear side lamination foils (13, 15), and
preparing a support structure (5) for supporting the photovoltaic label (3),
wherein the support structure (5) is prepared by
- arranging the photovoltaic label (3) between two moulding halves (23, 25) of a moulding device (27) being in an opened state,
- fixing the photovoltaic label (3) relative to either one of the moulding halves (23, 25),
- injecting a viscous polymer mass (29) to a rear surface (21) of the photovoltaic label (3),
- closing the moulding device (27) to a closed state by pushing either one of the moulding halves (23, 25) towards the other one so as to compress and thereby distribute the previously injected viscous polymer mass (29) across the rear surface (21) of the photovoltaic label (3), and
- after solidification of the injected polymer mass (29) thereby forming the support structure (5), opening the moulding device (27) by pulling either one the moulding halves (23, 25) away from the other one, and removing the photovoltaic label (3) with the support structure (5) attached thereto from the moulding device (27).

2. Method according to claim 1,
wherein the two moulding halves (23, 25) of the moulding device (27) comprise a core side moulding half (23) and a cavity side moulding half (25) being displaceable relative to each other between the open state and the closed state of the moulding device (27), wherein the core side moulding half (23) and a cavity side moulding half (25) are configured so as to, in the closed state of the moulding device (27), enclose a cavity (33), wherein the photovoltaic label (3) is arranged in the cavity (33) between the two moulding halves (23, 25) such that a front surface (19) of the photovoltaic label (3) is adjacent to an inner surface (35) of the core side moulding half (23) and a rear surface (21) of the photovoltaic label (3) is directed to an inner surface (37) of the cavity side moulding halve (25).

3. Method according to claim 2,
wherein the core side moulding half (23) and the cavity side moulding half (25) are configured such that, in the closed state of the moulding device (27), the cavity (33) is formed such that the inner surface (37) of the cavity side moulding half (25) is spaced apart from the rear surface (21) of the photovoltaic label (3) by at least 0.5 mm at least in a partial area of the photovoltaic label (3) in which the photovoltaic label (3) encloses the solar cell arrangement (17).

4. Method according to one of the preceding claims,
wherein the viscous polymer mass (29) is injected such that and wherein the two moulding halves (23, 25) are configured such that and pushed together such that the injected polymer mass (29) is distributed across the rear surface (21) of the photovoltaic label (3) so as to form a continuous layer (39) abutting to the photovoltaic label (3) at least in a partial area of the photovoltaic label (3) in which the photovoltaic label (3) encloses the solar cell arrangement (17).

5. Method according to one of the preceding claims,
wherein the viscous polymer mass (29) is injected at multiple injection locations (41) distributed along the rear surface (21) of the photovoltaic label (3).

6. Method according to one of the preceding claims,
wherein injecting the viscous polymer mass (29) is started before closing the moulding device (27).

7. Method according to one of the preceding claims,
wherein the viscous polymer mass (29) is injected during closing the moulding device (27).

8. Method according to one of the preceding claims,
wherein, at an initial stage of an injection procedure, the viscous polymer mass (29) is injected at a first number of injection locations (43), and
wherein, at a later stage of the injection procedure, the viscous polymer mass (29) is injected at a second number of injection locations (45) including injection locations other than the injection locations (43) included in the first number of injection locations (43).

9. Method according to one of the preceding claims,
wherein the viscous polymer mass (29) is injected with a pressure of less than 4000 bar, in particular, the injection pressure may be in a range between 1000 and 3000 bar, and wherein a closing pressure of the moulding device may preferably be less than 6000 tons or even less than 4000 tons, and most preferably about 2500 tons.

10. Method according to one of the preceding claims,
wherein the polymer mass (29) comprises a polymer configured to at least one of adhering and forming a positive substance jointing with the polymer of a rear-most one of the rear side polymeric lamination foil (13) and the optional rear side polymeric stabilisation foil (15).

11. Method according to one of the preceding claims,
wherein the polymer mass (29) comprises a blend of acrylonitrile butadiene styrene and polycarbonate.

12. Moulding device (27) comprising:
- a core side moulding half (23) and a cavity side moulding half (25) being displaceable relative to each other between an open state and a closed state, wherein the core side moulding half (23) and the cavity side moulding half (25) are configured so as to, in the closed state of the moulding device (27), enclose a cavity (33),
- a fixation arrangement (47) configured for temporarily fixing a sheet-like photovoltaic label (3) at either the core side moulding half (23) or the cavity side moulding half (25),
- an injection arrangement (51) configured for injecting a viscous polymer mass (29) into the cavity (33) to the rear surface (21) of the photovoltaic label (3) upon the photovoltaic label (3) being arranged between the core side moulding half (23) and the cavity side moulding half (25).

13. Moulding device of claim 12 being configured for implementing the method according to one of claims 1 to 11.
